Europäisches Patentamt

European Patent Office

Office européen des brevets

(19)

(11) Numéro de publication : **0 116 503 B1**

(12) **FASCICULE DE BREVET EUROPÉEN**

(45) Date de publication du fascicule du brevet :
15.04.87

(51) Int. Cl.⁴ : **G 12 B 15/06, H 01 L 23/42**

(21) Numéro de dépôt : 84400223.8

(22) Date de dépôt : 02.02.84

(54) **Procédé de réalisation d'un dispositif de stockage d'énergie thermique, et dispositif obtenu par ce procédé.**

(30) Priorité : 02.02.83 FR 8301624

(43) Date de publication de la demande :
22.08.84 Bulletin 84/34

(45) Mention de la délivrance du brevet :
15.04.87 Bulletin 87/16

(84) Etats contractants désignés :
DE FR GB IT SE

(56) Documents cités :
CH-A- 546 480
DE-A- 2 916 839
DE-A- 3 003 573
FR-A- 2 417 065
GB-A- 1 298 674
US-A- 2 145 308
US-A- 3 215 194
US-A- 4 335 781

(73) Titulaire : **THOMSON-CSF**
**173, Boulevard Haussmann**
**F-75379 Paris Cedex 08 (FR)**

**SOCIETE BERTIN**
**B.P. 3**
**F-78370 Plaisir (FR)**

(72) Inventeur : **Berland, Robert**
**THOMSON-CSF SCPI 173, bld Haussmann**
**F-75379 Paris Cedex 08 (FR)**
Inventeur : **Sem, Patrick**
**THOMSON-CSF SCPI 173, bld Haussmann**
**F-75379 Paris Cedex 08 (FR)**
Inventeur : **Patureau, Jean-Pierre**
**SOCIETE BERTIN B.P. 3**
**F-78370 Plaisir (FR)**
Inventeur : **Wintrebert, Gilles**
**SOCIETE BERTIN B.P. 3**
**F-78370 Plaisir (FR)**

(74) Mandataire : **Benoit, Monique et al**
**THOMSON-CSF SCPI 19, avenue de Messine**
**F-75008 Paris (FR)**

## Description

La présente invention concerne un dispositif de stockage d'énergie thermique dissipée par un équipement.

La dissipation de puissances élevées par un équipement peut en perturber le fonctionnement. Il est donc souvent nécessaire d'absorber cette énergie afin d'assurer le contrôle de la température de fonctionnement. C'est le cas des composants électroniques pour lesquels la puissance dissipée doit être absorbée très rapidement.

Deux types de stockage d'énergie sont utilisés pour le refroidissement et le conditionnement d'équipements :

Le premier type de réservoir thermique fonctionne sur le principe de l'accumulation d'énergie par « chaleur sensible » : le stockage de l'énergie est alors lié à la capacité calorifique d'une masse thermique, sans qu'il se produise un changement de phase.

Toutefois, l'élévation de température de la masse thermique, provoquée par l'absorption d'énergie, n'est pas uniforme, ce qui diminue l'efficacité d'absorption. De plus la température de conditionnement varie.

Enfin un réservoir thermique utilisant l'accumulation par chaleur sensible présente le plus souvent un poids et un volume importants, ce qui est préjudiciable à une application aéroportée par exemple.

Le deuxième type de réservoir thermique fonctionne sur le principe de l'accumulation de l'énergie par « chaleur latente » :

Il se compose d'une enveloppe contenant un corps à changement de phase. En général initialement solide, le matériau fond en absorbant de l'énergie. La fusion se produit à température constante si le matériau est un corps pur ou un eutectique.

Cette solution présente l'avantage de ne pas modifier la température du conditionnement.

Parmi les dispositifs connus appartenant à ce deuxième type, on peut citer les solutions proposées par les trois études suivantes pour résoudre un tel problème :

1) « Design Development and Space Qualification of a Prototype Phase-Change-Material Device » — Final Report. E.S.A. A. Abhat — Stuttgart (06/76)

2) « Thermal Capacitor, Liquid Coolant — to — Phase Change Material Heat Exchanger for the NASA SKYLAB I AIRLOCK MODULE ». Mc Donnell Douglas Astr. C. — J. Stafford — St. Louis (04/71)

3) « Thermal Control Through Fusible Materials » Motorola Aerospace Center — V. Duffy — Arizona (07/70)

Les deux premières études concernent la régulation thermique dans un satellite pour le maintien d'équipements à une température supérieure à 10 °C lors des cycles alternés soleil/ombre sur orbite.

La troisième étude concerne la régulation thermique d'un équipement électronique embarqué dans un missile à 80 °C pendant 60 mn de vol.

Dans les trois cas, la puissance et le flux thermique dissipés sont respectivement de l'ordre de 80 W et 700 W/m².

Le corps fusible utilisé est de la paraffine à l'intérieur d'une structure en nid d'abeille afin de favoriser les échanges thermiques.

Une telle solution utilisant une structure en nid d'abeille est inapplicable au cas où le flux thermique, donc le gradient thermique, est très élevé et où la puissance doit être absorbée en un temps très court, ce qui est par exemple le cas lors de la régulation thermique d'un émetteur état solide embarqué à bord d'un missile. Dans ce cas précis la puissance électrique et le flux dissipés peuvent atteindre en effet respectivement 2 500 W et 25 000 W/m² et la durée de fonctionnement exigée est de l'ordre de 50 secondes. Or le nid d'abeille présente une résistance thermique élevée et par conséquent une médiocre conduction thermique et un gradient thermique important entre la source chaude et le corps fusible.

D'autre part il est connu du brevet US-A-2, 145,308 de refroidir pour une longue durée un fluide à l'aide d'un autre fluide. Le refroidissement est effectué en établissant une circulation du liquide réfrigérant en dessous du liquide à refroidir et en plaçant des conducteurs thermiques dans le liquide à refroidir. Ce dispositif comprend deux réservoirs, des conducteurs thermiques et la circulation d'un fluide.

Il est également connu du brevet US-A-3,215,194, un dispositif d'absorption d'énergie qui permet d'absorber l'énergie dégagée par un semiconducteur placé sur une plaque conductrice thermiquement et qui est reliée thermiquement par des conducteurs, ces conducteurs étant eux mêmes reliés thermiquement à d'autres conducteurs plongés dans une substance à changement de phase contenue dans deux containers. Ce dispositif comprend deux réservoirs, une substance à changement de phase, plusieurs niveaux de conducteurs thermiques.

La présente invention permet de remédier aux inconvénients précités et a pour objet tout d'abord un procédé de réalisation d'un dispositif de stockage d'énergie thermique et ensuite un dispositif de stockage d'énergie par changement de phase d'un matériau permettant d'absorber très rapidement avec un faible gradient de température des flux thermiques élevés dissipés par un équipement, ceci afin d'assurer son conditionnement thermique et le contrôle de sa température de fonctionnement à la température de changement de phase.

Selon l'invention, le dispositif de stockage d'énergie thermique est un réservoir contenant un matériau à changement de phase auquel les flux de puissance sont transmis par l'intermédiaire d'une structure de transmission présentant une résistance thermique faible et une surface d'échanges thermiques optimisée avec le matériau à changement de phase.

Plus particulièrement selon l'invention,

le dispositif de stockage d'énergie thermique dissipée par un équipement, comprend un réservoir, une pluralité d'ailettes, un matériau à changement de phase, et est caractérisé en ce que :

le réservoir comprend deux plaques parallèles de matériau thermique conducteur distantes d'une hauteur (h), une virole périphérique constituant un ensemble fermé avec les deux plaques, une ouverture de remplissage ;

les ailettes ont une hauteur égale à la hauteur intérieure (h) du réservoir, et elles sont constituées par des feuilles de matériau à résistance thermique faible, pliées à pas constant pour être en contact avec les deux plaques et former un assemblage de cellules communiquant entre elles ;

le matériau à changement de phase remplit en phase liquide le volume intérieur total du réservoir ; le réservoir ainsi rempli étant fermé hermétiquement.

Un avantage du dispositif de stockage d'énergie selon l'invention est une optimisation du poids et du volume.

Un autre avantage de la présente invention est sa rigidité mécanique qui permet d'utiliser le dispositif comme support de composants électroniques ou comme cloison pour le système dans lequel il est incorporé.

Un autre avantage de la présente invention est l'absence de pièce en mouvement donc un conditionnement fiable à une température constante.

La présente invention sera mieux comprise à la lecture de la description détaillée faite ci-après avec référence aux figures ci-annexées qui représentent :

Figures 1a à 1d, les différents éléments formant une vue éclatée du dispositif de stockage d'énergie selon l'invention ;

Figure 2, un premier mode de réalisation de l'élément représenté par la figure 1c ; et

Figure 3, un deuxième mode de réalisation de l'élément représenté par la figure 1c.

Ainsi qu'on l'a déjà mentionné, le problème posé est l'absorption par un moyen statique, en un temps limité, d'un flux élevé de puissance dissipé par un équipement.

Selon l'invention le moyen statique est un dispositif de stockage d'énergie, ou réservoir, thermique contenant un matériau à changement de phase auquel les flux de puissance sont transmis par l'intemédiaire d'une structure dite de transmission dont le rôle est de favoriser la conduction depuis l'enveloppe extérieure du réservoir vers le matériau à changement de phase et qui est donc fortement conductrice. Etant donné le rôle qu'elle a à assumer, la structure de transmission présente une résistance thermique faible et, avec le matériau à changement de phase, une surface d'échanges thermiques très importante.

Dans la suite de la description on appellera matériau PCM le matériau à changement de phase. Son rôle est d'absorber la puissance dissipée par l'équipement sous forme de chaleur latente en maintenant une température voisine de la température de changement de phase pendant la durée prévue.

Le changement de phase peut être du type solide/gaz, liquide/gaz ou solide/liquide.

L'utilisation d'un matériau PCM à changement de phase solide/gaz ou liquide/gaz est peu souhaitable pour plusieurs raisons :

L'augmentation non négligeable de la pression interne peut avoir des conséquences sur la rigidité du réservoir. Le volume nécessaire à l'expansion du gaz implique un encombrement supérieur du réservoir. De plus la transformation en gaz débutant au niveau des échanges thermiques entre la structure de transmission et le matériau PCM isole de par la présence du gaz en formation les ailettes du matériau PCM, ce qui a pour conséquence d'augmenter le gradient thermique entre celles-ci et le matériau PCM. Il se forme donc un point chaud à la surface du réservoir, ce qui est justement à éviter.

Selon un mode de réalisation préférentiel, on choisit donc un matériau PCM à changement de phase solide/liquide. Les critères de choix sont indiqués dans la suite de la description.

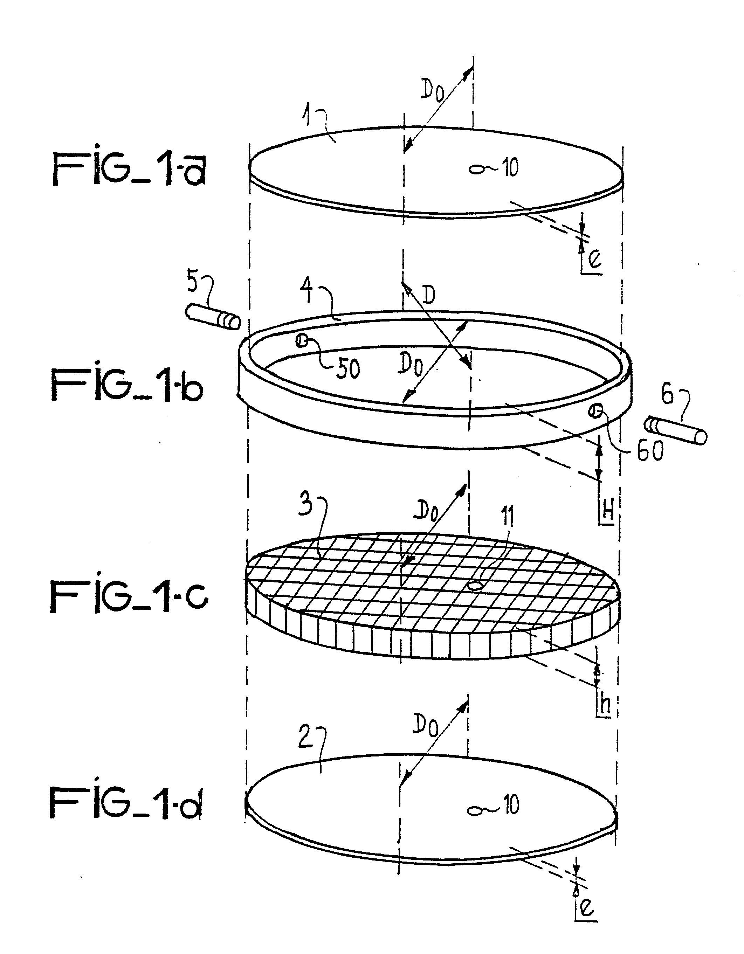

Les figures 1a à 1d représentent en une vue éclatée, les éléments mécaniques constitutifs du dispositif de stockage de flux thermique selon l'invention, ce dispositif ayant une forme cylindrique. Cette forme n'est nullement limitative et tout ce qui suit s'applique à toute autre forme, notamment parallélépipédique.

L'enveloppe du réservoir a pour rôle de contenir le matériau PCM et la structure de transmission. Elle est en contact thermique par ses faces avec l'équipement dissipateur d'énergie mais peut également supporter directement cet équipement. L'enveloppe est par conséquent rigide. Cette condition est en particulier indispensable lorsque sont implantés sur ses faces des composants électroniques qui doivent être maintenus fixes les uns par rapport aux autres. La géométrie de l'enveloppe est de préférence adaptée à celle de l'équipement.

Dans le mode de réalisation représenté par les figures 1a à 1d, l'équipement (non représenté) dissipe de l'énergie thermique sur l'une ou sur les deux faces 1, 2 d'une enveloppe en forme de cylindre peu épais. Les deux faces 1, 2 circulaires (Figs. 1a et 1d) sont en matériau thermiquement conducteur, planes, parallèles et distantes de la hauteur nécessaire pour contenir le matériau fusible. Une virole périphérique 4 (Fig. 1b) ferme le réservoir. Dans un autre exemple de réalisation, le réservoir peut être parallélépipédique.

Le diamètre intérieur Do de la virole 4 est égal au diamètre des faces supérieure et inférieure 1, 2 et à celui de la structure de transmission qui, noyée dans le matériau PCM, est désignée par la référence 3 et est représentée schématiquement par la figure 1c.

Les dimensions du réservoir, donc de chaque élément, sont déterminées par le cas de fonctionnement prévu et défini par la puissance électrique dissipée par l'équipement, par la durée de fonctionnement, par le volume disponible pour ce réservoir, et par l'excursion admissible (en °C) au-dessus du point de fusion.

La forme circulaire des deux faces 1, 2 n'est pas limitative et dépend, ainsi qu'on l'a déjà mentionné, de l'équipement qu'elles supporteront et du volume disponible.

Le réservoir est destiné à être fermé définitivement après son remplissage avec le matériau PCM :

Selon un mode de réalisation non limitatif, la paroi de la virole 4 présente deux ouvertures 50, 60, diamétralement opposés et destinés à recevoir chacun un tube de remplissage 5, 6 fixé de façon étanche à la virole 4. Une fois le réservoir rempli par le matériau PCM, ces ouvertures 50, 60 sont rebouchées afin de fermer hermétiquement le réservoir. Le mode de remplissage sera décrit ultérieurement de façon détaillée.

## Fabrication du réservoir

Le réservoir thermique peut être réalisé par exemple de la façon suivante (dans le cas d'un réservoir cylindrique tel qu'illustré par les figures 1a à 1d) :

La structure de transmission 3 de hauteur h est d'abord fixée, par brasage au bain de sel par exemple, à deux plaques carrées ayant une certaine épaisseur e. L'ensemble est ensuite découpé au diamètre $D_0$ désiré. Puis la virole 4 est elle-même découpée dans un tube dont le diamètre intérieur est $D_0$ et dont le diamètre extérieur D et la hauteur H (= h + 2e) correspondent respectivement au diamètre et à la hauteur définitive du réservoir. La virole 4 vient s'adapter à la périphérie de l'ensemble brasé et découpé 1, 2, 3 et est soudée sous argon aux faces 1 et 2. Le réservoir ainsi réalisé est rigide et indéformable en pression et en dépression. Il est alors rempli puis bouché hermétiquement. La découpe de l'ensemble constitué par les deux plaques 1 et 2 et les ailettes n'est pas obligatoire ; on peut utiliser par exemple deux plaques de dimensions déjà adaptées aux équipements, qu'il n'est plus nécessaire de découper une fois la mise en place des ailettes entre elles.

## Choix du matériau à changement de phase

Le matériau à changement de phase PCM est choisi selon un certain nombre de critères.

En effet son rôle est d'absorber la puissance dissipée par l'équipement (composants électroniques par exemple) sous forme de chaleur latente de fusion et de maintenir une température voisine de la température de fusion pendant la durée prévue.

Le matériau ne doit pas être fondu pendant le stockage. La température de fusion doit donc être supérieure à la température maximum de stockage et voisine de la température de fonctionnement prévue pour l'équipement.

Le matériau PCM doit présenter entre autres :

une grande chaleur latente de fusion ;

une réversibilité complète de la transition solide/liquide ;

une grande conductivité thermique afin de limiter les gradients thermiques dans le matériau ;

une grande chaleur massique ;

une fiabilité de la solidification : il ne doit y avoir aucun retard à la solidification en dessous de la température de fusion ;

une expansion volumique la plus faible possible lors de la fusion ;

une faible pression de vapeur pour limiter la pression dans le réservoir lorsqu'on admet un volume de compensation ;

une facilité de mise en œuvre en ce qui concerne la toxicité (pour les utilisateurs) et la corrosion (du réservoir, chimiquement inerte) ;

un poids et un volume compatibles avec l'application à laquelle le réservoir est destiné.

Le choix du matériau PCM doit correspondre à un compromis entre les caractéristiques techniques énoncées ci-dessus.

Dans l'application dont il est question plus haut, à savoir la régulation thermique de composants électroniques à bord d'un missile à une température de fonctionnement voisine de 80°, le choix se porte de façon préférentielle mais non limitative sur l'acétamide ($CH_3 CONH_2$).

## Dimensionnement du réservoir

La structure de transmission 3, comme on l'a déjà mentionné, a pour rôle de favoriser la conduction de l'enveloppe du réservoir vers le matériau PCM. Elle est de préférence métallique et la surface d'échanges thermiques qu'elle présente est suffisamment importante pour compenser la conductance médiocre dans le matériau PCM lui-même.

Le flux à absorber par le réservoir exige une extension de la surface d'échange. Ceci peut être réalisé par des « ailettes » perpendiculaires aux faces supérieure et inférieure 1,2 du réservoir.

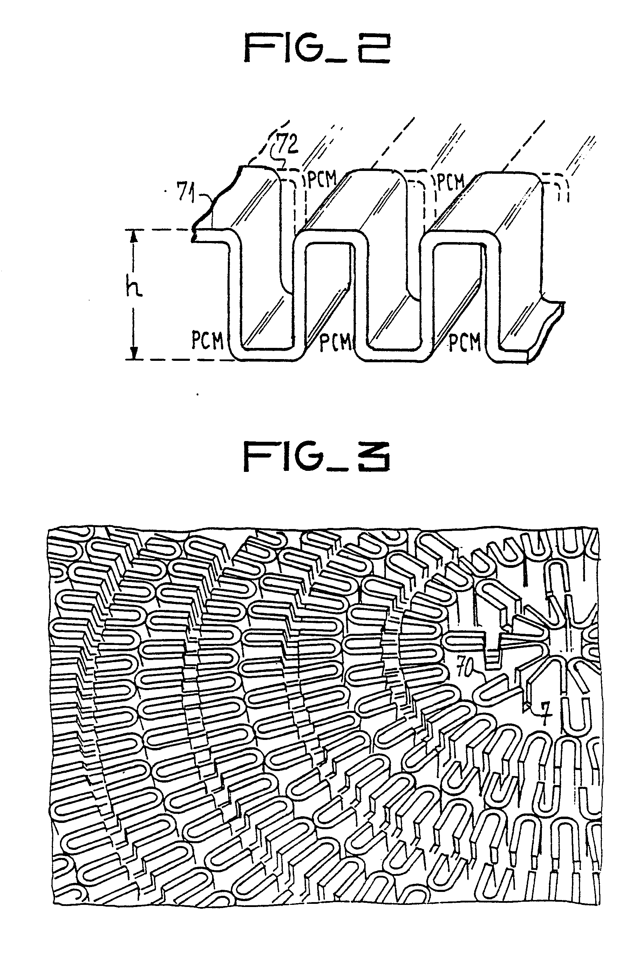

Le problème de la réalisation de ces ailettes respectant un écartement qui permette de dissiper un flux très élevé et qui peut donc être très faible est déterminant et sera étudié et décrit plus en détail en référence aux figures 2 et 3.

Une fois que le matériau PCM a été choisi, les dimensions du réservoir cylindrique et des ailettes sont déterminées selon le principe suivant :

On suppose la température du matériau PCM uniforme à la température de fusion, à l'instant initial t = 0, ceci afin d'assurer un dimensionnement dans le cas le plus défavorable.

Ainsi qu'on l'a déjà mentionné, les contraintes suivantes sont à la base du problème de régulation thermique à résoudre : la puissance P dissipée (en watts), le temps de dissipation to (en secondes), la surface $A_0$ de chaque face du réservoir (en m²) et l'excursion de température T (en °C) admissible au-dessus du point de fusion $T_f$ sont donnés.

Il est possible d'optimiser, grâce à un modèle mathématique non décrit ici, le compromis entre le volume engendré par l'extension de la surface de transmission par les ailettes et les différentes données précitées en considérant comme paramètres les constantes thermodynamiques des matériaux choisis pour le réservoir et le corps à changement de phase PCM.

Remplissage du réservoir

Le remplissage du réservoir se fait après l'assemblage complet de celui-ci.

Le matériau PCM est introduit à l'état liquide à la température maximum d'utilisation afin d'éviter une dilatation du matériau supérieure au volume du réservoir. Pour permettre un remplissage uniforme du volume intérieure du réservoir par l'intermédiaire des tubes de remplissage 5, 6, les cellules formées par les ailettes de la structure de transmission 3 doivent communiquer entre elles. Lorsque le remplissage a lieu sous vide poussé, une seule ouverture de remplissage 5 est nécessaire, quelle que soit la forme du réservoir. Lorsque le réservoir est de forme parallélépipédique, et que le remplissage ne se fait pas sous vide poussé, les deux ouvertures doivent être judicieusement placées pour assurer le remplissage total du réservoir.

Dans le cas où le matériau PCM est très fluide à l'état liquide (cas de l'acétamide par exemple), les trous de communication peuvent être très réduits.

Le réservoir rempli est fermé définitivement au niveau des ouvertures de remplissage 50, 60. La masse de matériau PCM incluse subit des variations volumiques dues à la dilatation thermique et à l'expansion au cours du changement de phase.

La capacité du réservoir doit être prévue à partir de la masse volumique à la température de remplissage.

A l'état solide, le matériau PCM est contracté et il existe un vide de retrait dans le réservoir. Afin d'assurer une répartition homogène du vide de retrait à l'intérieur du réservoir, les orifices de communication entre cellules sont réalisés à proximité de la face du réservoir sur laquelle la solidification a lieu le plus tôt. Ils sont ainsi obstrués rapidement par le matériau solidifié.

La structure « à ailettes » est, de façon préférentielle mais non limitative, réalisée dans le même matériau métallique que l'enveloppe du réservoir. Le métal de l'enveloppe doit être surtout bon conducteur afin de répartir sur toute la surface du réservoir l'énergie dissipée : En effet dans le cas de composantes électroniques par exemple, la position des composants peut engendrer une dissipation irrégulière de puissance sur la face. De même le métal constituant les « ailettes » doit être très bon conducteur afin de transmettre au mieux ce flux thermique au matériau PCM.

Selon les applications, le choix se porte principalement sur le cuivre ou l'aluminium pour des raisons de poids et de compatibilités électrochimiques avec les matériaux utilisés pour les équipements voisins ou avec le matériau PCM lui-même.

Modes de réalisation de la structure de transmission

La structure 3 à ailettes peut, étant donné les considérations pratiques précédentes, présenter les modes de réalisation préférentiels mais non limitatifs illustrés par les figures 2 et 3.

Selon la figure 2, la structure 3 est constituée par une onde « plissée » : Une feuille mince est pliée mécaniquement en accordéon avec un certain pas et sur une hauteur h correspondant à l'épaiseur intérieur du réservoir de façon à pouvoir être fixée à la paroi de celui-ci. Cette technique de pliage permet d'obtenir des pas très faibles jusqu'à 1,16 mm avec une feuille d'épaisseur 0,2 mm.

Pour faire communiquer les cellules entre elles, condition indispensable au remplissage du réservoir, deux ondes plissées juxtaposées 71, 72 sont décalées latéralement l'une par rapport à l'autre.

Ce mode de réalisation permet d'obtenir un bon contact métallique par brasage et par conséquent une bonne conduction thermique.

Selon la figure 3, la structure 3 est constituée par une onde découpée en bandes de largeur h adaptée à l'épaiseur intérieur du réservoir de façon à pouvoir fixer les bandes à la paroi de celui-ci. Les bandes 70 sont pliées, posées sur la tranche et juxtaposées de façon à remplir le volume du réservoir (en cercles concentriques par exemple dans le cas d'un réservoir cylindrique).

Cette deuxième solution est plus délicate technologiquement mais apporte une meilleure réponse à l'adaptation dimensionnelle et à l'isolement des celules à la solidification. De plus la souplesse de l'onde permet de s'adapter à des formes variées. Le découpage de l'onde en bandes de largeur h permet de choisir l'épaiseur indépendamment des standards de pliage.

Enfin, pour répondre à l'exigence de communication des cellules, on pratique des rainures 7 sur chacune des deux tranches des ailettes, les orifices ainsi pratiqués se trouvant placés à proximité des faces du réservoir.

Cette deuxième solution présente une plus faible surface de contact entre l'onde et les faces du réservoir et une moins bonne planéité de la structure de transmission « à ailettes » 3. Le brasage de l'onde sur tranche (Fig. 3) est donc plus délicat que celui de l'onde plissée de la figure 2.

Le découpage des bandes peut se faire par électro-érosion, ce qui assure une tolérance très faible sur les hauteurs h de la structure 3.

Fixation de l'équipement au réservoir

On a dit auparavant que l'équipement dissipateur d'énergie devait être fixé au dispositif de stockage d'énergie selon l'invention, par des moyens destinés de plus à assurer la conduction de la chaleur de cet équipement vers le dispositif. L'équipement est fixé soit directement sur une des plaques du dispositif, soit par l'intermédiaire d'équerres métalliques, les moyens de fixation étant logés à l'intérieur même du dispositif en regard de trous 10 percés dans les plaques. Ces moyens sont disposés entre les ailettes 3, en regard des trous pratiqués dans les plaques 1 et 2, de même hauteur que la hauteur intérieure h du réservoir et soudées à celles-ci. Ces moyens peuvent être par exemple des tubes cylindriques 11 métalliques dans lesquels sont logées des vis venant maintenir l'équipement ou les équerres au réservoir.

Selon un mode de réalisation préférentiel particulièrement destiné à une application aéroportée, la structure de transmission 3 est constituée d'ondes plissées (Fig. 2) fabriquées à partir de feuilles d'aluminium d'épaisseur 0,2 mm. Les plis sont au nombre de 22 tous les 25,4 mm et ont une hauteur h = 12,7 mm. Le matériau à changement de phase PCM est de l'acétamide dont la température de fusion est de 81 °C.

L'enveloppe extérieure du réservoir cylindrique est en aluminium également. Les faces 1 et 2 ont chacune une épaisseur e = 0,8 mm. Les diamètres extérieur et intérieur de la virole sont respectivement D = 250 mm et Do = 238 mm.

Les résultats obtenus sont les suivants :

Le flux absorbé s'élève à 25 400 W/m² pendant 60 secondes. La température de départ étant de 70 °C environ, la température à la surface du réservoir n'augmente que de 18 °C.

On a ainsi réalisé un réservoir capable d'absorber des flux thermiques extrêmement importants tels que ceux dissipés par un équipement électronique, un émetteur « état solide » par exemple.

De plus, étant léger peu encombrant, il est particulièrement destiné aux applications aéroportées.

## Revendications

1. Dispositif de stockage d'énergie thermique dissipée par un équipement, comprenant un réservoir, une pluralité d'ailettes, un matériau à changement de phase, caractérisé en ce que :

le réservoir (1, 2, 4) comprend deux plaques parallèles (1 et 2) de matériau thermique conducteur distantes d'une hauteur (h), une virole périphérique (4) constituant un ensemble fermé avec les deux plaques, une ouverture de remplissage (50) ;

les ailettes (3) ont une hauteur égale à la hauteur intérieure (h) du réservoir (1, 2, 4), et elles sont constituées par des feuilles de matériau à résistance thermique faible, pliées à pas constant pour être en contact avec les deux plaques et former un assemblage de cellules communiquant entre elles ;

le matériau à changement de phase remplit en phase liquide le volume intérieur total du réservoir ; le réservoir ainsi rempli étant fermé hermétiquement.

2. Dispositif selon la revendication 1, caractérisé en ce que chaque feuille mince (71) de matériau à résistance thermique faible pliée à pas constant, sur une hauteur correspondant à la hauteur (h) intérieure du réservoir, est disposée de façon à former des séries consécutives de cellules présentant un décalage latéral régulier permettant la mise en communication des cellules d'une série avec celles d'une autre série.

3. Dispositif selon la revendication 2, caractérisé en ce que les différentes séries de celules sont disposées parallèlement les unes aux autres.

4. Dispositif selon la revendication 1, caractérisé en ce que chaque feuille mince (70) de matériau à résistance thermique faible, découpée en bandes de largeur égale à la hauteur intérieure (h) du réservoir pliée à pas constant est posée sur la tranche, et en ce qu'elle comporte une rainure centrale (7) pratiquée sur chacune des deux tranches en contact avec les plaques (1 et 2), ces ailettes étant disposées par bandes conductrices juxtaposées de façon à former des séries de cellules dans tout le réservoir.

5. Dispositif selon l'une des revendications 1 à 4, caractérisé en ce que les deux plaques (1 et 2) comportent des trous (10) placés en regard les uns des autres et en ce qu'il comporte des moyens permettant la fixation de l'équipement au dispositif disposés, entre les ailettes en regard des trous pratiqués dans les plaques, de même hauteur que la hauteur intérieure (h) du réservoir (1, 2, 4) et soudées aux deux plaques (1 et 2), destinées de plus à assurer la conduction de la chaleur de l'équipement vers le dispositif.

6. Dispositif selon la revendication 5, caractérisé en ce que les moyens de fixation sont constitués par des tubes cylindriques métalliques.

7. Dispositif selon l'une des revendications 1 à 6, caractérisé en ce que le réservoir est de forme parallélépipédique.

8. Dispositif selon l'une des revendications 1 à 6, caractérisé en ce que le réservoir est de forme cylindrique.

9. Dispositif selon les revendications 4 à 8, caractérisé en ce que les différentes séries de cellules sont disposées de façon concentrique autour du centre du réservoir.

10. Dispositif selon la revendication 8, caractérisé en ce que la virole (4) présente au moins deux ouvertures (50 et 60) diamétralement opposées et reliées chacune de façon étanche à un tube de remplissage (5 et 6).

11. Dispositif selon l'une des revendications 1 à 10, caractérisé en ce que le réservoir et les ailettes sont métalliques, en aluminium par exemple.

12. Dispositif selon l'une des revendications 1 à 11, caractérisé en ce que le matériau à changement de phase est de l'acétamine.

## Claims

1. A device for storing thermal energy which is dissipated by an equipment, comprising a tank, a plurality of ribs, a material with phase conversion, characterized in that :

the tank (1, 2, 4) comprises two parallel plates (1 and 2) of thermally conductive material which are distant to each other by a height (h), a peripheral ring (4) constituting a closed unit with the two plates, a filling opening (50) ;

the ribs (3) have a height equal to the inner height (h) of the tank (1, 2, 4) and they are constituted by sheets of a material of low thermal resistance, which are pleated regularly so as to be in contact with the two plates and to form an assembly of intercommunicating cells ;

the material with phase conversion fills in the liquid phase the total inner volume of the tank ; the tank thus filled being hermetically closed.

2. A device according to claim 1, characterized in that each thin sheet (71) of material having a low thermal resistance and being regularly pleated over a height corresponding to the inner height (h) of the tank, is disposed so as to form consecutive series of cells presenting a regular lateral shift permitting the connection of the cells of one series to the cells of another series.

3. A device according to claim 2, characterized in that the different series of cells are disposed parallelly to each other.

4. A device according to claim 1, characterized in that each thin sheet (70) of a material having a low thermal resistance and being cut into bands of a width equal to the inner height (h) of the tank and regularly pleated is disposed on the edge, and that it comprises a central groove (7) made in each of the two edges in contact with the plates (1 and 2), the ribs being disposed in adjacent conductive bands so as to form series of cells in the entire tank.

5. A device according to one of claims 1 to 4, characterized in that the two plates (1 and 2) comprise holes (10) placed facing each other and in that it comprises means permitting the fixation of the equipment on the device, these means being disposed between the ribs in alignment with the holes in the plates, being of the same height as the inner height (h) of the tank (1, 2, 4) and being welded to the two plates (1 and 2), these means being further destined to ensure the conduction of the heat from the equipment to the device.

6. A device according to claim 5, characterized in that the fixation means are constituted by cylindrical metal tubes.

7. A device according to one of claims 1 to 6, characterized in that the tank has a parallelepipedic form.

8. A device according to one of claims 1 to 6, characterized in that the tank has a cylindrical form.

9. A device according to one of claims 4 to 8, characterized in that the different series of cells are disposed concentrically around the center of the tank.

10. A device according to claim 8, characterized in that the ring (4) has at least two openings (50 and 60) which are diametrically opposed and tightly connected to a respective filling tube (5 and 6).

11. A device according to one of claims 1 to 10, characterized in that the tank and the ribs are made of metal, for example of aluminium.

12. A device according to one of claims 1 to 11, characterized in that the material with phase conversion is acetamine.

## Patentansprüche

1. Vorrichtung zum Speichern von einem Gerät abgegebener Wärmeenergie, mit einem Tank, einer Vielzahl von Rippen, einem Material mit Phasenumwandlung, dadurch gekennzeichnet, daß :

der Tank (1, 2, 4) zwei parallele Platten (1 und 2) aus thermisch leitendem Material, die einen Höhenabstand (h) voneinander haben, einen peripheren Ring (4), der mit den beiden Platten eine geschlossene Einheit bildet, und eine Füllöffnung (50) aufweist ;

die Rippen (3) eine Höhe gleich der inneren lichten Höhe (h) des Tanks haben und aus Folien eines Materials mit geringem thermischem Widerstand bestehen, die in gleichmäßigem Abstand gefaltet sind, um mit den beiden Platten in Kontakt zu stehen und eine Satz von miteinander in Verbindung stehenden Zellen zu bilden ;

das Material mit Phasenumwandlung in der flüssigen Phase das ganze innere Volumen des Tanks füllt und der so gefüllte Tank hermetisch verschlossen ist.

2. Vorrichtung nach Anspruch 1, dadurch gekennzeichnet, daß jede dünne Folie (71) aus über eine der inneren lichten Höhe (h) des Tanks entsprechenden Höhe gleichmäßig gefaltetem Material mit geringem thermischem Widerstand so angeordnet ist, daß aufeinanderfolgende Serien von Zellen gebildet werden, die eine regelmäßige seitliche Verschiebung aufweisen, wodurch die Verbindung der Zellen einer Serie mit denen einer anderen Serie ermöglicht wird.

3. Vorrichtung nach Anspruch 2, dadurch gekennzeichnet, daß die verschiedenen Serien von Zellen zueinander parallel angeordnet sind.

4. Vorrichtung nach Anspruch 1, dadurch gekennzeichnet, daß jede dünne Folie (70) aus Material mit geringem thermischem Widerstand, das in Bänder einer der inneren lichten Höhe (h) entsprechenden Breite zerschnitten und mit gleichmäßigem Abstand gefaltet ist, auf die Schnittkante gelegt ist und daß die Folie eine zentrale Nut (7) aufweist, die in jeder der beiden mit den Platten (1 und 2) in Kontakt stehenden Schnittkanten angebracht ist, wobei die Rippen in nebeneinanderliegenden leitenden Bändern angeordnet sind, um Serien von Zellen in dem gesamten Tank zu bilden.

5. Vorrichtung nach einem der Ansprüche 1 bis 4, dadurch gekennzeichnet, daß die beiden Platten (1 und 2) Löcher (10) aufweisen, die einander gegenüberliegend angeordnet sind, und daß sie Mittel aufweist, die die Befestigung des Geräts an der Vorrichtung ermöglichen und zwischen den Rippen in Flucht zu den in den Platten angebrachten Löchern liegen sowie von gleicher Höhe wie die innere Höhe (h) des Tanks (1, 2, 4) sind und an die beiden Platten (1 und 2) angeschweißt sind, wobei diese Mittel weiter dazu bestimmt sind, die Wärmeleitung von dem Gerät zur Vorrichtung zu bewirken.

6. Vorrichtung nach Anspruch 5, dadurch gekennzeichnet, daß die Befestigungsmittel aus zylindrischen Metallrohren bestehen.

7. Vorrichtung nach einem der Ansprüche 1 bis 6, dadurch gekennzeichnet, daß der Tank parallelepipedische Form hat.

8. Vorrichtung nach einem der Ansprüche 1 bis 6, dadurch gekennzeichnet, daß der Tank zylindrische Form hat.

9. Vorrichtung nach einem der Ansprüche 4 bis 8, dadurch gekennzeichnet, daß die verschiedenen Serien von Zellen in konzentrischer Form um das Zentrum des Tanks herum angeordnet sind.

10. Vorrichtung nach Anspruch 8, dadurch gekennzeichnet, daß der Ring (4) mindestens zwei Öffnungen (50 und 60) aufweist, die einander entgegengesetzt sind und jede dicht mit einem Füllrohr (5 und 6) verbunden ist.

11. Vorrichtung nach einem der Ansprüche 1 bis 10, dadurch gekennzeichnet, daß der Tank und die Rippen aus Metall, z. B. aus Aluminium sind.

12. Vorrichtung nach einem der Ansprüche 1 bis 11, dadurch gekennzeichnet, daß das Material mit Phasenumwandlung Acetamin ist.

FIG_1-a

FIG_1-b

FIG_1-c

FIG_1-d

# FIG_2

# FIG_3